# EUROPÄISCHE PATENTSCHRIFT

(11) **EP 1 206 173 B1**
(45) Veröffentlichungstag und Bekanntmachung des Hinweises auf die Patenterteilung: **09.08.2006**
(21) Anmeldenummer: 01126166.6
(22) Anmeldetag: 03.11.2001
(51) Int. Cl.: H05K 7/20, H05K 5/00, H02K 19/36, H01L 23/367, H02K 11/04

(54) **Kühlkörper-Leiterbahnen-Anordnung**
Cooling element - conductive paths assembly
Arrangement élément de refroidissement - pistes conductrices

(30) Priorität: 09.11.2000 DE 20019053 U
(43) Veröffentlichungstag der Anmeldung: 15.05.2002
(73) Patentinhaber: ROBERT BOSCH GMBH, 70442 Stuttgart (DE)
(72) Erfinder: Stilke, Henning, 28844 Leeste (DE); Bilsing, Thomas, 74357 Boennigheim (DE)

(56) Entgegenhaltungen:
- EP-A- 0 712 160
- US-A- 5 619 108
- US-A- 5 677 616

## Beschreibung

Die Erfindung betrifft eine Kühlkörper-Leiterbahnen-Anordnung für elektrische Geräte gemäß dem Oberbegriff des Anspruchs 1.

Eine derartige Kühlkörper-Leiterbahnen-Anordnung ist aus der US 5 677 616 bekannt. Auf einem Kühlkörper ist eine elektrisch isolierende Basisplatte angeordnet, in welcher eine Leiterbahnen-Einheit eingebettet ist. Das Leistungsvermögen dieser Kühlkörper-Leiterbahnen-Anordnung ist nicht zufrieden stellend.

Die EP 0 712 160 A2 offenbart eine Kühlkörper-Leiterbahnen-Anordnung, die einen Kühlkörper und ein Gehäuse umfasst. Durch das Gehäuse läuft eine Leiterbahn.

Eine in der US 5 619 108 offenbarte Kühlkörper-Leiterbahnen-Anordnung umfasst eine auf einem Kühlkörper angeordnete Steuereinheit, die mehrere Leiterbahnen aufweist. Auf die Steuereinheit ist ein Adapter mit weiteren Leiterbahnen gesetzt. Nachteilig bei dieser bekannten Kühlkörper-Leiterbahnen-Anordnung ist die besonders hohe Störanfälligkeit.

Bei der Herstellung von Kühlkörper-Leiterbahnen-Anordnungen werden häufig Basisplatten mit darin befindlichen Leiterbahnen auf einen Kühlkörper aufgelegt und anschließend umspritzt. Entlang der Kontaktfläche zwischen Basisplatte und Kühlkörper befinden sich Hohlräume, die beim späteren Betrieb ein Eindringen von Feuchtigkeit sowie die Entstehung von Kriechströmen verursachen können.Der Erfindung liegt die Aufgabe zugrunde, eine Kühlkörper-Leiterbahnen-Anordnung zu schaffen, die einerseits möglichst fehlerfrei arbeitet und andererseits ein hohes Leistungsvermögen besitzt.

Die Aufgabe wird durch die im kennzeichnenden Teil des Anspruches 1 angegebenen Merkmale gelöst. Der Kern der Erfindung besteht darin, die Basisplatte und den Kühlkörper derart flächig miteinander zu verbinden, dass entlang der Kontaktfläche keine Lufteinschlüsse verbleiben. Die Kühlkörper-Leiterbahnen-Anordnung weist außerdem eine zweite Leiterbahnen-Einheit auf.

Weitere vorteilhafte Ausgestaltungen der Erfindung ergeben sich aus den Unteransprüchen.

Zusätzliche Merkmale und Einzelheiten ergeben sich aus der Beschreibung eine Ausführungsbeispiels anhand der Zeichnung. Es zeigt:

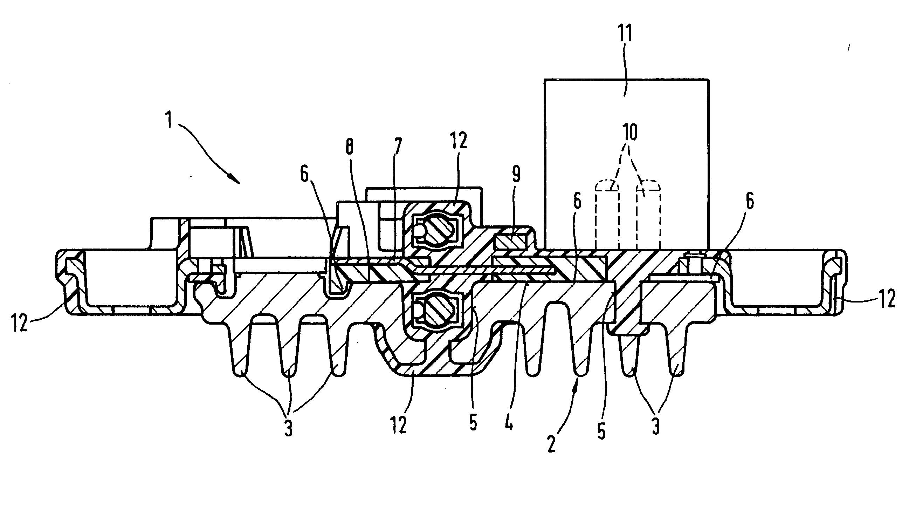

Fig. 1 eine Querschnittsdarstellung einer Kühlkörper-Leiterbahnen-Anordnung gemäß der Erfindung.

Eine Kühlkörper-Leiterbahnen-Anordnung 1 für einen biopolaren Spannungsregler eines Generators weist einen Kühlkörper 2 auf, der nach unten vorstehende Kühllamellen 3 besitzt. Der Kühlkörper 2 weist auf seiner Oberseite eine im wesentlichen flache Auflagefläche 4 auf, die von Ausnehmungen 5 durchbrochen ist. Auf dem Kühlkörper 2 ist eine Basisplatte 6 angeordnet. Die Basisplatte 6 besteht aus einer aus einem Basisplatten-Material bestehenden Kunststoffmatrix, in die eine erste Einheit von Leiterbahnen 7 oder Stromschienen eingebettet ist. Die Basisplatte 6 bildet einen sogenannten Vorumspritzling, der die Leiterbahnen 7 aufnimmt, so daß diese bei der Montage einfach auf dem Kühlkörper 2 plaziert werden können. Die Basisplatte 6 ist entlang ihrer gesamten Unterseite 8 mit der Auflagefläche 4 des Kühlkörpers 2 möglichst großflächig verklebt. Die Verklebung ist derart ausgebildet, daß sich entlang der gesamten Kontaktfläche zwischen der Unterseite 8 und der Auflagefläche 4 keine Gasblasen befinden. Auf der Basisplatte 6 ist eine zweite Einheit von Leiterbahnen 9 angeordnet. Diese sind durch das Basisplatten-Material gegenüber den Leiterbahnen 7 elektrisch isoliert. Ferner sind von der Basisplatte 6 vorstehende Steckzapfen 10 vorgesehen, die von einer Steckdose 11 umgeben sind.

Die Basisplatte 6, die Leiterbahnen 9 sowie Teile des Kühlkörpers 2 sind mit einem Deck-Material aus Kunststoff umspritzt, das eine Deckschicht 12 bildet. Auf diese Weise wird die Anordnung 1 zur Umgebung hin elektrisch isoliert und gleichzeitig gegenüber Feuchtigkeit von außen unempfindlich. Das Deckschicht-Material und das Basisplatten-Material, die aus dem selben Kunststoff bestehen können, verbinden sich, je nach Kunststoff, mehr oder weniger miteinander.

Im folgenden wird das Herstellungsverfahren der Kühlkörper-Leiterbahnen-Anordnung 1. kurz beschrieben. Zunächst wird die Basisplatte 6 durch Umspritzen der Leiterbahnen 7 mit Basisplatten-Material hergestellt. Anschließend werden die Leiterbahnen 9 auf der Basisplatte 6 angeordnet. Anschließend wird die Basisplatte 6 flächig und ohne Luftblasen auf den Kühlkörper 2 aufgeklebt. Anschließend wird die gesamte Anordnung mit Deck-Material umspritzt. Durch die flächige Klebeverbindung zwischen Basisplatte 6 und Kühlkörper 2 befinden sich innerhalb der Deckschicht 12 keine Luftblasen, so daß ein möglichst homogener Gesamtkörper entsteht. Durch die Vermeidung von Hohlräumen werden Kriechströme und Elektrolyse verhindert.

## Patentansprüche

1. Kühlkörper-Leiterbahnen-Anordnung, insbesondere für elektrische Geräte,
a) mit einem Kühlkörper (2) zur Abführung von Wärme an die Umgebung und
b) mit einer Basisplatte (6), welche
i) ein elektrisch isolierendes Basisplatten-Material aufweist,
ii) eine erste, in dem Basisplatten-Material eingebettete Leiterbahnen-Einheit (7) aufweist und
iii) flächig mit dem Kühlkörper (2) verbunden ist,
**dadurch gekennzeichnet, dass**
c) auf der Basisplatte (6) eine zweite Leiterbahnen-Einheit (9) angeordnet ist,
d) zumindest ein Teil des Kühlkörpers (2), der Basisplatte (6) sowie der zweiten Leiterbahnen-Einheit (9) mit einem elektrisch isolierenden Deck-Material umspritzt sind, und
e) das Deck-Material und das Basisplatten-Material untrennbar miteinander verbunden sind.

2. Kühlkörper-Leiterbahnen-Anordnung gemäß Anspruch 1, **dadurch gekennzeichnet, dass** die Basisplatte (6) mit dem Kühlkörper (2) verklebt ist.

3. Kühlkörper-Leiterbahnen-Anordnung gemäß Anspruch 1 oder 2, **dadurch gekennzeichnet, dass** sich entlang der Kontaktfläche zwischen dem Kühlkörper (2) und der Basisplatte (6) keine Gasblasen befinden.

4. Kühlkörper-Leiterbahnen-Anordnung gemäß Anspruch 1, **dadurch gekennzeichnet, dass** es sich bei dem Basisplatten-Material und/oder dem Deck-Material um einen spritzfähigen Kunststoff handelt.

## Claims

1. Cooling element - conductive paths assembly, in particular for electrical equipment,
a) with a cooling element (2) for dissipating heat to the surroundings and
b) with a base plate (6), which
i) comprises an electrically insulating base-plate material,
ii) has a first conductive paths unit (7), embedded in the base-plate material, and
iii) is connected with surface-area contact to the cooling element (2),
**characterized in that**
c) a second conductive paths unit (9) is arranged on the base plate (6),
d) at least part of the cooling element (2), of the base plate (6) and of the second conductive paths unit (9) is encapsulated with an electrically insulating cover material and
e) the cover material and the base-plate material are inseparably connected to each other.

2. Cooling element - conductive paths assembly according to Claim 1, **characterized in that** the base plate (6) is adhesively bonded to the cooling element (2).

3. Cooling element - conductive paths assembly according to Claim 1 or 2, **characterized in that** there must not be any gas bubbles along the contact surface area between the cooling element (2) and the base plate (6).

4. Cooling element - conductive paths assembly according to Claim 1, **characterized in that** the base-plate material and/or the cover material is/are an injection-mouldable plastic.

## Revendications

1. Ensemble élément de refroidissement-pistes conductrices, en particulier pour des appareils électriques, comprenant
a) un élément de refroidissement (2) pour évacuer de la chaleur dans l'environnement et
b) une plaque de base (6), qui
i) comprend une matière de plaque de base électriquement isolante,
ii) comprend une première unité de pistes conductrices (7) noyée dans la matière de plaque de base, et
iii) est assemblée à plat avec l'élément de refroidissement (2),
**caractérisé en ce que**
c) une deuxième unité de pistes conductrices (9) est disposée sur la plaque de base (6),
d) au moins une partie de l'élément de refroidissement (2), de la plaque de base (6) ainsi que de la deuxième unité de pistes conductrices (9) est surmoulée par injection d'une matière de recouvrement électriquement isolante, et
e) la matière de recouvrement et la matière de plaque de base sont solidarisée l'une à l'autre de manière inséparable.

2. Ensemble élément de refroidissement-pistes conductrices selon la revendication 1,
**caractérisé en ce que**
la plaque de base (6) est collée à l'élément de refroidissement (2).

3. Ensemble élément de refroidissement-pistes conductrices selon la revendication 1 ou 2,
**caractérisé par**
l'absence de bulles de gaz le long de la face de contact entre l'élément de refroidissement (2) et la plaque de base (6).

4. Ensemble élément de refroidissement-pistes conductrices selon la revendication 1,
**caractérisé en ce que**
la matière de plaque de base et/ ou la matière de recouvrement est/ sont une matière plastique injectable.
